# EUROPÄISCHE PATENTSCHRIFT

(11) **EP 1 409 577 B1**
(45) Veröffentlichungstag und Bekanntmachung des Hinweises auf die Patenterteilung: **25.07.2007**
(21) Anmeldenummer: 02743254.1
(22) Anmeldetag: 03.07.2002
(51) Int. Cl.: C08K 5/00, C08L 67/02

(54) **FLAMMGESCHÜTZTE THERMOPLASTISCHE FORMMASSEN**
FLAME RESISTANT THERMOPLASTIC MOULDING MATERIALS
MATIERES A MOULER THERMOPLASTIQUES IGNIFUGEES

(30) Priorität: 05.07.2001 DE 10132057
(43) Veröffentlichungstag der Anmeldung: 21.04.2004
(73) Patentinhaber: BASF Aktiengesellschaft, 67056 Ludwigshafen (DE)
(72) Erfinder: GEPRÄGS, Michael, 01987 Schwarzheide (DE)
(86) Internationale Anmeldenummer: PCT/EP2002/007339
(87) Internationale Veröffentlichungsnummer: WO 2003/004553

(56) Entgegenhaltungen:
- US-A- 4 061 810
- US-A- 4 857 673
- DATABASE WPI Section Ch, Week 199012 Derwent Publications Ltd., London, GB; Class A23, AN 1990-088449 XP002216861 & JP 02 043253 A (KANEGAFUCHI CHEM KK), 13. Februar 1990 (1990-02-13)
- PATENT ABSTRACTS OF JAPAN vol. 004, no. 061 (C-009), 8. Mai 1980 (1980-05-08) & JP 55 029542 A (MITSUI TOATSU CHEM INC), 1. März 1980 (1980-03-01)
- DATABASE WPI Section Ch, Week 197734 Derwent Publications Ltd., London, GB; Class A60, AN 1977-60195Y XP002216862 & JP 52 082941 A (MITSUBISHI CHEM IND LTD) , 11. Juli 1977 (1977-07-11)

## Beschreibung

Die Erfindung betrifft thermoplastische Formmassen enthaltend
A) 10 bis 98 Gew.-% mindestens eines thermoplastischen Polyesters
B) 1 bis 30 Gew.-% einer Flammschutzmittelkombination aus, bezogen auf 100 Gew.-% B),
   b₁) 20 bis 99 Gew.-% eines halogenhaltigen Flammschutzmittels
   b₂) 1 bis 80 Gew.-% eines Antimonoxides
C) 0,01 bis 5 Gew.-% Weinsäure oder Tartrate oder deren Mischungen
D) 0 ist 5 Gew.-% mindestens einen phosphorhaltigen Stabilisator
E) 0 bis 70 Gew.-% weiterer Zusatzstoffe, wobei die Summe der Gewichtsprozente der Komponenten A) bis E) 100 % ergibt.

Weiterhin betrifft die Erfindung die Verwendung der erfindungsgemäßen Formmassen zur Herstellung von Fasern, Folien und Formkörper jeglicher Art.

Aus der US 4,532,290 und US 3,953,539 sind PC/Polyester Blends bekannt, welche Phosphate als Inhibitoren für die Umesterung bzw. als Farbstabilisatoren enthalten.

Aus der EP-A 543 128 sind derartige Blends, welche auch halogenierte Polycarbonate enthalten können, mit Umesterungsinhibitoren auf Basis von Zink- bzw. Calciumdihydrogenphosphat (sog. saure Phosphate) bekannt.

Für halogenhaltige, insbesondere niedermolekulare, Poly- oder Oligocarbonate, die als Flammschutzmittel für Polyester eingesetzt werden können, besteht nach wie vor eine technische Problemstellung bezüglich des Kristallisationsverhalten und der Fließfähigkeit derartiger Formmassen.

Bei der Umesterungsreaktion zwischen Polycarbonat und Polyester bilden sich Blockcopolymere, welche eine breite Molgewichtsverteilung aufweisen und ein schlechteres Kristallisationsverhalten zeigen. Dieses zeigt sich insbesondere in der schnell sinkenden Kristallisationstemperatur, so dass der Spritzguss- oder Blasformverarbeitungsprozess negativ beeinflussen wird.

Aus der DE-A 197 535 42 ist weiterhin bekannt, dass niedermolekulare halogenfreie Säuren wie Zitronensäure als Stabilisator für kautschukhaltige Polyester/Polycarbonat blends eingesetzt werden können.

Aufgabe der vorliegenden Erfindung war es daher, flammgeschützte Polyesterformmassen zur Verfügung zu stellen, die ein verbessertes Kristallisationsverhalten bei der Verarbeitung aufweisen, sowie eine bessere Fließfähigkeit zeigen.

Demgemäß wurden die eingangs definierten Formmassen gefunden. Bevorzugte Ausführungsformen sind den Unteransprüchen zu entnehmen.

Überraschenderweise führte diese Kombination von insbesondere oligomeren, halogenhaltigen Flammschutzmitteln mit Polyestern und Weinsäure bzw. Tartraten zu einem Kristallisationsverhalten, bei welchem über einen längeren Zeitraum und bei wiederholten Aufschmelzen eine hohe Kristallisationstemperatur erhalten bleibt. Damit verbunden ist eine kürzere Zykluszeit und kürzere Entfernungszeiten sowie eine geringere Klebeneigung.

Als Komponente (A) enthalten die erfindungsgemäßen Formmassen 10 bis 98, bevorzugt 10 bis 97 und insbesondere 30 bis 80 Gew.-% eines thermoplastischen Polyesters.

Allgemein werden Polyester A) auf Basis von aromatischen Dicarbonsäuren und einer aliphatischen oder aromatischen Dihydroxyverbindung verwendet.

Eine erste Gruppe bevorzugter Polyester sind Polyalkylenterephthalate insbesondere mit 2 bis 10 C-Atomen im Alkoholteil.

Derartige Polyalkylenterephthalate sind an sich bekannt und in der Literatur beschrieben. Sie enthalten einen aromatischen Ring in der Hauptkette, der von der aromatischen Dicarbonsäure stammt. Der aromatische Ring kann auch substituiert sein, z.B. durch Halogen wie Chlor und Brom oder durch C₁-C₄-Alkylgruppen wie Methyl-, Ethyl-, i- bzw. n-Propyl- und n-, i- bzw. t-Butylgruppen.

Diese Polyalkylenterephthalate können durch Umsetzung von aromatischen Dicarbonsäuren, deren Estern oder anderen esterbildenden Derivaten mit aliphatischen Dihydroxyverbindungen in an sich bekannter Weise hergestellt werden.

Als bevorzugte Dicarbonsäuren sind 2,6-Naphthalindicarbonsäure, Terephthalsäure und Isophthalsäure oder deren Mischungen zu nennen. Bis zu 30 mol-%, vorzugsweise nicht mehr als 10 mol-% der aromatischen Dicarbonsäuren können durch aliphatische oder cycloaliphatische Dicarbonsäuren wie Adipinsäure, Azelainsäure, Sebacinsäure, Dodecandisäuren und Cyclohexandicarbonsäuren ersetzt werden.

Von den aliphatischen Dihydroxyverbindungen werden Diole mit 2 bis 6 Kohlenstoffatomen, insbesondere 1,2-Ethandiol, 1,3-Propandiol, 1,4-Butandiol, 1,6-Hexandiol, 1,4-Hexandiol, 1,4-Cyclohexandiol, 1,4-Cyclohexandimethanol und Neopentylglykol oder deren Mischungen bevorzugt.

Als besonders bevorzugte Polyester (A) sind Polyalkylenterephthalate, die sich von Alkandiolen mit 2 bis 6 C-Atomen ableiten, zu nennen. Von diesen werden insbesondere Polyethylenterephthalat, Polypropylenterephthalat und Polybutylenterephthalat oder deren Mischungen bevorzugt. Weiterhin bevorzugt sind PET und/oder PBT, welche bis zu 1 Gew.-%, vorzugsweise bis zu 0,75 Gew.-% 1,6-Hexandiol und/oder 2-Methyl-1,5-Pentandiol als weitere Monomereinheiten enthalten.

Die Viskositätszahl der Polyester (A) liegt im allgemeinen im Bereich von 50 bis 220, vorzugsweise von 80 bis 160 (gemessen in einer 0,5 gew.-%igen Lösung in einem Phenol/o-Dichlorbenzolgemisch (Gew.-Verh. 1:1 bei 25°C) gemäß ISO 1628.

Insbesondere bevorzugt sind Polyester, deren Carboxylendgruppengehalt bis zu 100 mval/kg, bevorzugt bis zu 50 mval/kg und insbesondere bis zu 40 mval/kg Polyester beträgt. Derartige Polyester können beispielsweise nach dem Verfahren der DE-A 44 01 055 hergestellt werden. Der Carboxylendgruppengehalt wird üblicherweise durch Titrationsverfahren (z.B. Potentiometrie) bestimmt.

Insbesondere bevorzugte Formmassen enthalten als Komponente A) eine Mischung aus Polyestern, welche verschieden von PBT sind, wie beispielsweise Polyethylenterephthalat (PET). Der Anteil z.B. des Polyethylenterephthalates beträgt vorzugsweise in der

Mischung bis zu 50, insbesondere 10 bis 35 Gew.-%, bezogen auf 100 Gew.-% A).

Weiterhin ist es vorteilhaft PET Rezyklate (auch scrap-PET genannt) gegebenenfalls in Mischung mit Polyalkylenterephthalaten wie PBT einzusetzen.

Unter Rezyklaten versteht man im allgemeinen:
1) sog. Post Industrial Rezyklat: hierbei handelt es sich um Produktionsabfälle bei der Polykondensation oder bei der Verarbeitung z.B. Angüsse bei der Spritzgußverarbeitung, Anfahrware bei der Spritzgußverarbeitung oder Extrusion oder Randabschnitte von extrudierten Platten oder Folien.
2) Post Consumer Rezyklat: hierbei handelt es sich um Kunststoffartikel, die nach der Nutzung durch den Endverbraucher gesammelt und aufbereitet werden. Der mengenmäßig bei weitem dominierende Artikel sind blasgeformte PET Flaschen für Mineralwasser, Softdrinks und Säfte.

Beide Arten von Rezyklat können entweder als Mahlgut oder in Form von Granulat vorliegen. Im letzteren Fall werden die Rohrezyklate nach der Auftrennung und Reinigung in einem Extruder aufgeschmolzen und granuliert. Hierdurch wird meist das Handling, die Rieselfähigkeit und die Dosierbarkeit für weitere Verarbeitungsschritte erleichtert.

Sowohl granulierte als auch als Mahlgut vorliegende Rezyklate können zum Einsatz kommen, wobei die maximale Kantenlänge 6 mm, vorzugsweise kleiner 5 mm betragen sollte.

Aufgrund der hydrolytischen Spaltung von Polyestern bei der Verarbeitung (durch Feuchtigkeitsspuren) empfiehlt es sich, das Rezyklat vorzutrocknen. Der Restfeuchtegehalt nach der Trocknung beträgt vorzugsweise <0,2 %, insbesondere <0,05 %.

Als weitere Gruppe sind voll aromatische Polyester zu nennen, die sich von aromatischen Dicarbonsäuren und aromatischen Dihydroxyverbindungen ableiten.

Als aromatische Dicarbonsäuren eignen sich die bereits bei den Polyalkylenterephthalaten beschriebenen Verbindungen. Bevorzugt werden Mischungen aus 5 bis 100 mol-% Isophthalsäure und 0 bis 95 mol-% Terephthalsäure, insbesondere Mischungen von etwa 80 % Terephthalsäure mit 20 % Isophthalsäure bis etwa äquivalente Mischungen dieser beiden Säuren verwendet.

Die aromatischen Dihydroxyverbindungen haben vorzugsweise die allgemeine Formel 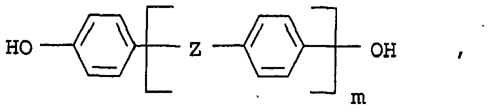 in der Z eine Alkylen- oder Cycloalkylengruppe mit bis zu 8 C-Atomen, eine Arylengruppe mit bis zu 12 C-Atomen, eine Carbonylgruppe, eine Sulfonylgruppe, ein Sauerstoff- oder Schwefelatom oder eine chemische Bindung darstellt und in der m den Wert 0 bis 2 hat. Die Verbindungen können an den Phenylengruppen auch C₁-C₆-Alkyl- oder Alkoxygruppen und Fluor, Chlor oder Brom als Substituenten tragen.

Als Stammkörper dieser Verbindungen seinen beispielsweise
Dihydroxydiphenyl,
Di-(hydroxyphenyl)alkan,
Di-(hydroxyphenyl) cycloalkan,
Di-(hydroxyphenyl)sulfid,
Di-(hydroxyphenyl)ether,
Di-(hydroxyphenyl)keton,
di-(hydroxyphenyl)sulfoxid,
α,α'-Di-(hydroxyphenyl)-dialkylbenzol,
Di-(hydroxyphenyl)sulfon, Di-(hydroxybenzoyl)benzol
Resorcin und
Hydrochinon sowie deren kernalkylierte oder kernhalogenierte Derivate genannt.

Von diesen werden
4,4'-Dihydroxydiphenyl,
2,4-Di-(4'-hydroxyphenyl)-2-methylbutan
α,α'-Di-(4-hydroxyphenyl)-p-diisopropylbenzol,
2,2-Di-(3'-methyl-4'-hydroxyphenyl)propan und
2,2-Di-(3'-chlor-4'-hydroxyphenyl)propan,
sowie insbesondere
2,2-Di-(4'-hydroxyphenyl)propan
2,2-Di-(3',5-dichlordihydroxyphenyl)propan,
1,1-Di-(4'-hydroxyphenyl)cyclohexan,
3,4'-Dihydroxybenzophenon,
4,4'-Dihydroxydiphenylsulfon und
2,2-Di(3',5'-dimethyl-4'-hydroxyphenyl)propan
oder deren Mischungen bevorzugt.

Selbstverständlich kann man auch Mischungen von Polyalkylenterephthalaten und vollaromatischen Polyestern einsetzen. Diese enthalten im allgemeinen 20 bis 98 Gew.-% des Polyalkylenterephthalates und 2 bis 80 Gew.-% des vollaromatischen Polyesters.

Selbstverständlich können auch Polyesterblockcopolymere wie Copolyetherester verwendet werden. Derartige Produkte sind an sich bekannt und in der Literatur, z.B. in der US-A 3 651 014, beschrieben. Auch im Handel sind entsprechende Produkte erhältlich, z.B. Hytrel^{®} (DuPont).

Als Polyester sollen erfindungsgemäß auch halogenfreie Polycarbonate verstanden werden. Geeignete halogenfreie Polycarbonate sind beispielsweise solche auf Basis von Diphenolen der allgemeinen Formel 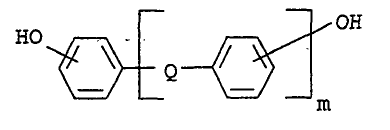 worin Q eine Einfachbindung, eine C₁- bis C₈-Alkylen-, eine C₂- bis C₃-Alkyliden-, eine C₃- bis C₆-Cycloalkylidengruppe, eine C₆- bis C₁₂-Arylengruppe sowie -O-, -S- oder -SO₂- bedeutet und m eine ganze Zahl von 0 bis 2 ist.

Die Diphenole können an den Phenylenresten auch Substituenten haben wie C₁- bis C₆-Alkyl oder C₁- bis C₆-Alkoxy.

Bevorzugte Diphenole der Formel sind beispielsweise Hydrochinon, Resorcin, 4,4'-Dihydroxydiphenyl, 2,2-Bis-(4-hydroxyphenyl)-propan, 2,4-Bis-(4-hydroxyphenyl)-2-methylbutan, 1,1-Bis-(4-hydroxyphenyl)-cyclohexan. Besonders bevorzugt sind 2,2-Bis-(4-hydroxyphenyl)-propan und 1,2-Bis-(4-hydroxyphenyl)-cyclohexan, sowie 1,1-Bis-(4-hydroxyphenyl)-3,3,5-trimethylcyclohexan.

Sowohl Homopolycarbonate als auch Copolycarbonate sind als Komponente A geeignet, bevorzugt sind neben dem Bisphenol A-Homopolymerisat die Copolycarbonate von Bisphenol A.

Die geeigneten Polycarbonate können in bekannter Weise verzweigt sein, und zwar vorzugsweise durch den Einbau von 0,05 bis 2,0 mol-%, bezogen auf die Summe der eingesetzten Diphenole, an mindestens trifunktionellen Verbindungen, beispielsweise solchen mit drei oder mehr als drei phenolischen OH-Gruppen.

Als besonders geeignet haben sich Polycarbonate erwiesen, die relative Viskositäten ηᵣₑₗ von 1,10 bis 1,50, insbesondere von 1,25 bis 1,40 aufweisen. Dies entspricht mittleren Molekulargewichten M_{w} (Gewichtsmittelwert) von 10 000 bis 200 000, vorzugsweise von 20 000 bis 80 000 g/mol.

Die Diphenole der allgemeinen Formel sind an sich bekannt oder nach bekannten Verfahren herstellbar.

Die Herstellung der Polycarbonate kann beispielsweise durch Umsetzung der Diphenole mit Phosgen nach dem Phasengrenzflächenverfahren oder mit Phosgen nach dem Verfahren in homogener Phase (dem sogenannten Pyridinverfahren) erfolgen, wobei das jeweils einzustellende Molekulargewicht in bekannter Weise durch eine entsprechende Menge an bekannten Kettenabbrechern erzielt wird. (Bezüglich polydiorganosiloxanhaltigen Polycarbonaten siehe beispielsweise DE-OS 33 34 782).

Geeignete Kettenabbrecher sind beispielsweise Phenol, p-t-Butylphenol aber auch langkettige Alkylphenole wie 4-(1,3-Tetramethylbutyl)-phenol, gemäß DE-OS 28 42 005 oder Monoalkylphenole oder Dialkylphenole mit insgesamt 8 bis 20 C-Atomen in den Alkylsubstituenten gemäß DE-A 35 06 472, wie p-Nonylphenyl, 3,5-di-t-Butylphenol, p-t-Octylphenol, p-Dodecylphenol, 2-(3,5-dimethyl-heptyl)-phenol und 4-(3,5-Dimethylheptyl)-phenol.

Halogenfreie Polycarbonate im Sinne der vorliegenden Erfindung bedeutet, daß die Polycarbonate aus halogenfreien Diphenolen, halogenfreien Kettenabbrechern und gegebenenfalls halogenfreien Verzweigern aufgebaut sind, wobei der Gehalt an untergeordneten ppm-Mengen an verseifbarem Chlor, resultierend beispielsweise aus der Herstellung der Polycarbonate mit Phosgen nach dem Phasengrenzflächenverfahren, nicht als halogenhaltig im Sinne der Erfindung anzusehen ist. Derartige Polycarbonate mit ppm-Gehalten an verseifbarem Chlor sind halogenfreie Polycarbonate im Sinne vorliegender Erfindung.

Als weitere geeignete Komponenten A) seien amorphe Polyestercarbonate genannt, wobei Phosgen gegen aromatische Dicarbonsäureeinheiten wie Isophthalsäure und/oder Terephthalsäureeinheiten, bei der Herstellung ersetzt wurde. Für nähere Einzelheiten sei an dieser Stelle auf die EP-A 711 810 verwiesen.

Weitere geeignete Copolycarbonate mit Cycloalkylresten als Monomereinheiten sind in der EP-A 365 916 beschrieben.

Weiterhin kann Bisphenol A durch Bisphenol TMC ersetzt werden. Derartige Polycarbonate sind unter dem Warenzeichen APEC HT^{®} der Firma Bayer erhältlich.

Als Komponente B) enthalten die erfindungsgemäßen Formmassen 1 bis 30, vorzugsweise 2 bis 25 und insbesondere 5 bis 20 Gew.-% einer Flammschutzmittelkombination aus
b₁) 20 bis 99, vorzugsweise 50 bis 85 Gew.-% eines halogenhaltigen Flammschutzmittels, vorzugsweise mit einem Polymerisationsgrad bzw. Oligomerisierungsgrad > 3, vorzugsweise > 4
b₂) 1 bis 80 Gew.-%, vorzugsweise 15 bis 50 Gew.-% eines Antimonoxides.

Bevorzugte Oxide b₂) sind Antimontrioxid und Antimonpentoxid. Zur besseren Dispergierung kann das Oxid b₂) in sogenannten Batches (Konzentraten) in das Polymer A) eingearbeitet werden, wobei im Konzentrat Thermoplaste beispielsweise eingesetzt werden können, welche Komponente A) entsprechen oder verschieden von der jeweiligen Komponente A) sind. Bevorzugt sind Konzentrate von b₂) in Polyolefinen, vorzugsweise Polyethylen.

Geeignete Flammschutzmittel b₁) sind vorzugsweise bromierte Verbindungen, wie bromierte Oligocarbonate (BC 52 oder BC 58 der Firma Great Lakes bzw. FG 7000 der Firma Teijin Chem.) der Strukturformel:

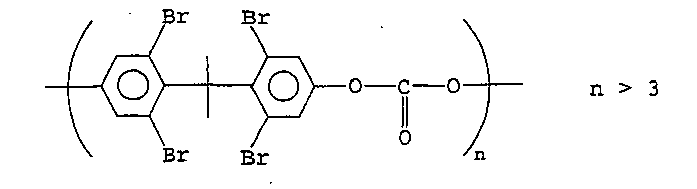

Weiterhin geeignet sind Polypentabrombenzylacrylate mit n > 4 (z.B. FR 1025 der Firma Dead Sea Bromine (DSB)) der Formel:

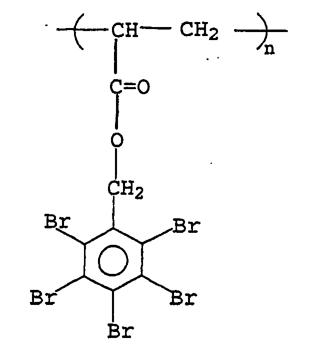

Bevorzugte bromierte Verbindungen sind weiterhin oligomere Umsetzungsprodukte (n > 3) aus Tetrabrom-bis-phenol-A mit Epoxiden (z.B. FR 2300 und 2400 der Firma DSB) der Formel:

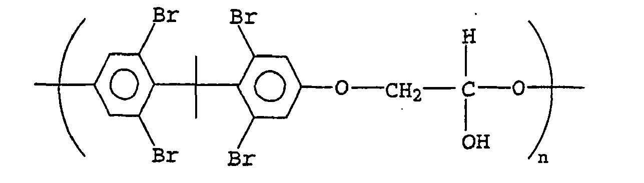

Die als Flammschutzmittel vorzugsweise eingesetzten bromierten Oligostyrole haben einen mittleren Polymerisationsgrad (Zahlenmittel) zwischen 4 und 90, vorzugsweise zwischen 5 und 60, gemessen dampfdruckosmometrisch in Toluol. Zyklische Oligomere sind ebenfalls geeignet. Gemäß einer bevorzugten Ausführungsform der Erfindung weisen die einzusetzenden bromierten oligomeren Styrole die nachstehende Formel I auf, in der R Wasserstoff oder ein aliphatischer Rest, insbesondere ein Alkylrest wie z.B. CH₂ oder C₂H₅ und n die Anzahl der sich wiederholenden Kettenbausteine bedeuten. R' kann sowohl H als auch Brom als auch ein Fragment eines üblichen Radikalbildners sein:

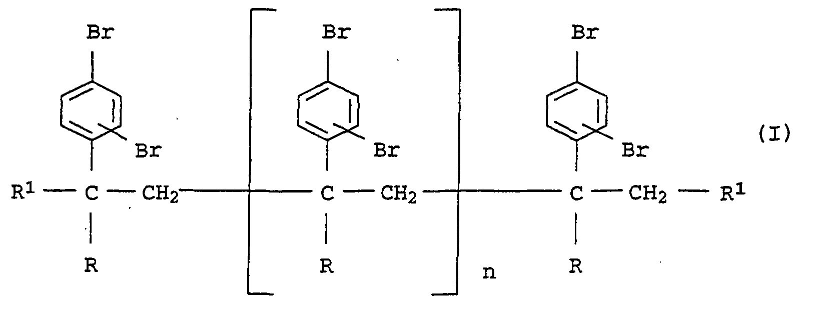

Der Wert n kann 4 - 88, vorzugsweise 4 - 58, betragen. Die bromierten Oligostyrole enthalten 40 bis 80 Gew.-% vorzugsweise 55 bis 70 Gew.-% Brom. Bevorzugt ist ein Produkt, das überwiegend aus Polydibromstyrol besteht. Die Substanzen sind unzersetzt schmelzbar und z. B. in Tetrahydrofuran löslich. Sie können hergestellt werden entweder durch Kernbromierung von - gegebenenfalls aliphatisch hydrierten - Styrololigomeren, wie sie z. B: durch thermische Polymerisation von Styrol erhalten werden (nach DT-OS 25 37 385) oder durch radikalische Oligomerisierung von geeigneten bromierten Styrolen. Die Herstellung des Flammschutzmittels kann auch durch ionische Oligomerisation von Styrol und anschließende Bromierung erfolgen. Die zur Flammfestausrüstung der Polyester notwendige Menge an bromiertem Oligostyrol hängt vom Bromgehalt ab. Der Bromgehalt in den erfindungsgemäßen Formmassen beträgt von 2 bis 20 Gew.-%, vorzugsweise von 5 bis 12 Gew.-%.

Die bromierten Polystyrole gemäß der Erfindung werden üblicherweise nach dem in der EP-A 47 549 beschriebenen Verfahren erhalten:

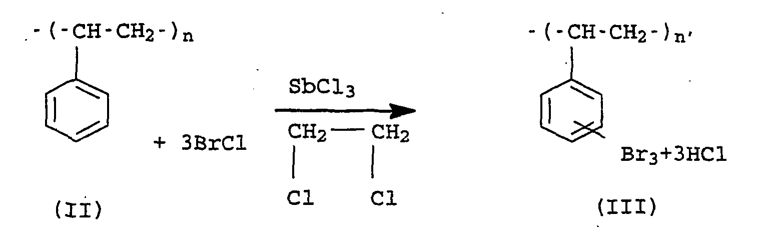

Die nach diesem Verfahren und im Handel erhältlichen bromierten Polystyrole sind vorwiegend kernsubstituierte tribromierte Produkte. n' (s. III) hat allgemein Werte von 120 bis 2000, was einem Molekulargewicht von 40000 bis 1000000 vorzugsweise von 130000 bis 800000 entspricht.

Der Bromgehalt (bezogen auf den Gehalt an kernsubstituiertem Brom) beträgt im allgemeinen mindestens 55, vorzugsweise mindestens 60 und insbesondere 68 Gew.-%.

Die im Handel erhältlichen pulverförmigen Produkte weisen im allgemeinen eine Glastemperatur von 160 bis 200°C auf und sind beispielsweise unter den Bezeichnungen HP 7010 der Firma Albemarle und Pyrocheck® PB 68 der Firma Ferro Corporation bzw. Saytex 7010 der Firma Albemarle erhältlich.

Es können auch Mischungen der bromierten Oligostyrole mit bromierten Polystyrolen in den erfindungsgemäßen Formmassen eingesetzt werden, wobei das Mischungsverhältnis beliebig ist.

Der Polymerisationsgrad n kann üblicherweise durch Bestimmung des Molekulargewichts ermittelt werden.

Dieser entspricht einem Molekulargewicht (Mₙ) > 2000, welches in der Regel mittels Membranosmometrie oder durch Lichtstreuung für M_{w} > 10000 bestimmt werden kann.

Weiterhin sind chlorhaltige Flammschutzmittel b₁) geeignet, wobei Dechlorane® plus der Firma Oxychem bevorzugt ist.

Als Komponente C) enthalten die erfindungsgemäßen Formmassen 0,01 bis 5, vorzugsweise 0,05 bis 2 und insbesondere 0,05 bis 1 Gew.-% Weinsäure oder Tartrate oder deren Mischungen. Unter Weinsäure versteht man im allgemeinen nach Römpp-Chemie Lexikon, 1992, Georg Thieme Verlag, Stuttgart, 9. Auflage, S. 5025-5027 2.3-Dihydroxybernsteinsäure, Threarsäure, Weinsteinsäure mit der Summenformel 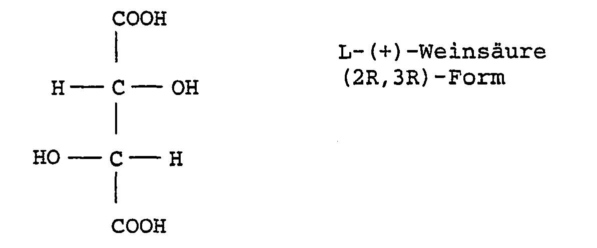 C₄H₆O₆, MG. 150.09. Weinsäure tritt in 3 stereoisomeren Formen auf: Die L-(+)Form [sog. natürliche W. (2R. 3R)-Form, Schmp. 169-170°, D²⁰, 1.7598], die D-(-)Form [(2S.3S)-Form, Schmp. 169-170°, D²⁰₄ 1.7598] u. die meso-Form [Schmp. 159-160°, D²⁰₄ 1.666 (andere Angabe 1.737)]. Weinsäure ist eine starke Säure (pKₐ₁ 2.98, pKₐ₂ 4.34, andere Angabe: pkₐ₁ 2.93, PKₐ₂ 4.23, jeweils bei 25°).

Die DL-(±)-Form von Weinsäure (racemische Weinsäure, Traubensäure, Vogesensäure, (CAS [133-37-9], Schmp. 205-206°) kommt nicht in der Natur vor, bildet sich jedoch in geringen Mengen bei der Weinherstellung bzw. neben meso-Weinsäure durch Erhitzen von L-Weinsäure in Natronlauge.

Die L-Form kommt in vielen Pflanzen u. Früchten vor, in freier Form u. als Kalium-, Calcium- oder Magnesium-Salz, z.B. im Traubensaft teils als freie Weinsäure, teils als Kaliumhydrogentartrat, das sich als Weinstein zusammen mit Calciumtartrat nach der Gärung des Weines abscheidet. D-Weinsäure, die auch als unnatürliche Weinsäure bezeichnet wird, ist in der Natur sehr selten, sie findet sich in den Blättern des westafrikanischen Baumes Bankinia reticulata.

Weinstein wird üblicherweise mit Calciumchlorid od. Calciumhydroxid in Calciumtartrat umgewandelt. Hieraus werden mit Schwefelsäure Weinsäure und Gips freigesetzt. Weinsäure ist damit ein Nebenprodukt der Weinerzeugung. DL- bzw. meso-Weinsäure erhält man bei der Oxidation von Fumarsäure oder Maleinsäureanhydrid mit Wasserstoffperoxid, Kaliumpermanganat, Persäuren, in Gegenwart von Wolframsäure in technischem Maßstab. In kleinen Mengen kann man D-Weinsäure aus racemischer Weinsäure mit Penicillium glaucum, das nur L-Weinsäure abbaut, erhalten.

Gemäß Römpp s.o., S. 4457 versteht man unter Tartraten die Ester und Salze der Weinsäure. Wenn nur 1 H der beiden Carboxygruppen durch organische Reste oder Metalle ersetzt ist, enthält man im allgemeinen die sog. sauren bzw. Hydrogentartrate (auch Bitartrate genannt).

Bevorzugte Tartrate sind die Salze der Weinsäure, insbesondere solche Salze, die mit Erdalkali- oder Alkaliionen gebildet werden.

Als bevorzugte Erdalkali- bzw. Alkalisalze seien Brechweinstein (Kaliumantimon(III)oxidtartrat)

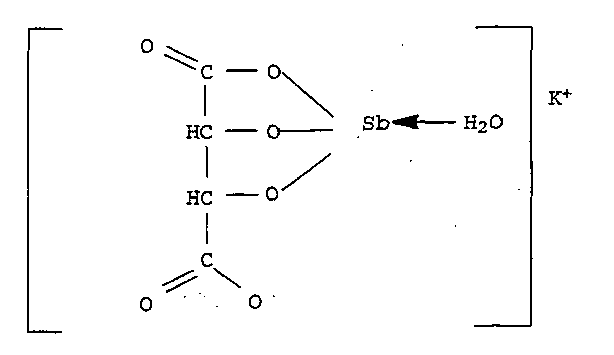

Weinstein (Kaliumhydrogentartrat), Seignettesalz (Kaliumnatriumtartrat), Natrium-, sowie Natriumhydrogentartrat oder deren Mischungen genannt. Weitere geeignete Salze sind Kaliumammoniumtartrat, Natriumammoniumtartrat oder Ammoniumtartrat.

Als Ester eignen sich solche, welche sich von Alkoholen mit 1 bis 10 C-Atomen ableiten lassen, vorzugsweise aliphatische Alkylgruppen.

Als Komponente D) können die erfindungsgemäßen Formmassen 0 bis 5, vorzugsweise 0,1 bis 5 und insbesondere 0,1 bis 2 Gew.-% eines phosphorhaltigen Stabilisators enthalten.

Geeignete Stabilisatoren sind vorzugsweise organische Phosphonite D) der allgemeinen Formel I 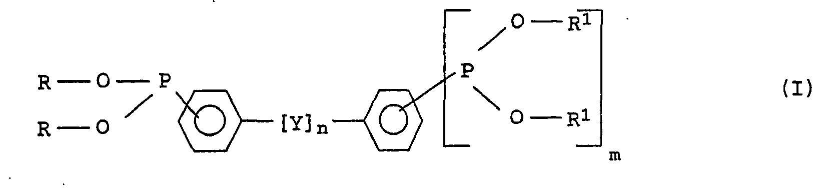 worin
- m: 0 oder 1,
- n: 0 oder 1,
- y: eine Sauerstoff-, Schwefel- oder 1,4-Phenylen-Brücke oder ein Brückenglied der Formel -CH(R²)-; alle R-O- und R¹-O-Gruppen unabhängig voneinander, den Rest eines aliphatischen, alicyclischen oder aromatischen Alkohols der bis zu drei Hydroxylgruppen enthalten sein kann, wobei jedoch die Hydroxylgruppen nicht so angeordnet sind, daß sie Teile eines Phosphor-enthaltenden Ringes sein können (als monovalente R-O-Gruppen bezeichnet),
oder je zwei an ein Phosphoratom gebundene R-O-, bzw. R¹-O-Grupp jeweils unabhängig voneinander zusammen den Rest eines aliphatischen, alicyclischen oder aromatischen Alkohols mit insgesamt bis zu drei Hydroxylgruppen (als bivalente R-O-, bzw. R¹-O-Gruppen bezeichnet),
- R²: Wasserstoff, C₁-C₈-Alkyl oder eine Gruppe der Formel COOR³ und
- R³: C₁₋₈-Alkyl bedeuten.

Bevorzugt ist mindestens eine R-O und mindestens R¹-O-Gruppe, ein Phenolrest, welcher in 2-Stellung eine sterisch gehinderte Gruppe, insbesondere t-Butylreste, trägt.

Besonders bevorzugt ist Tetrakis-(2,4-di-tert.-butylphenyl)-biphenylen-diphosphonit, welches als Irgafos^{®} PEPQ der Firma Ciba Spezialitätenchemie GmbH im Handel erhältlich ist:

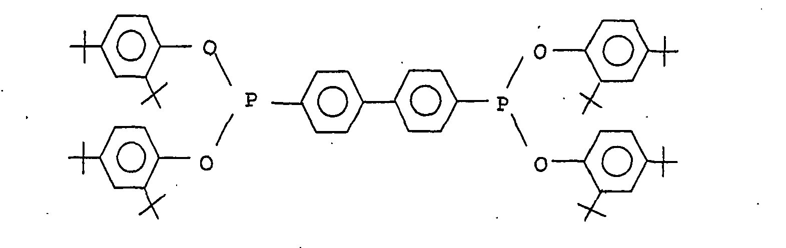

Wenn R-O- und R¹-O- divalente Reste sind, leiten sie sich vorzugs weise von zwei oder dreiwertigen Alkoholen ab.

Vorzugsweise bedeutet R gleich R¹ und dieses ist Alkyl, Aralkyl (vorzugsweise gegebenenfalls subst. Phenyl oder Phenylen), Aryl (vorzugsweise gegebenenfalls subst. Phenyl) oder eine Gruppe der Formel α 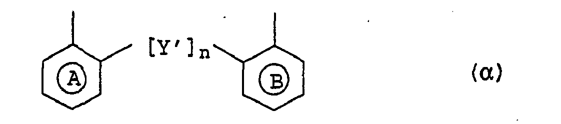 worin die Kerne A und B weitere Substituenten tragen können und Y' eine Sauerstoff- oder Schwefelbrücke oder ein Brückenglied der Formel -CH(R³)-,
- R²: Wasserstoff, C₁-C₈-Alkyl oder eine Gruppe der Formel -COOR³ und
- R³: C₁₋₈-Alkyl und
- n: 0 oder 1 bedeuten (als divalentes R' bezeichnet).

Besonders bevorzugte Reste R sind die Reste R", wobei dieses C₁₋₂₂-Alkyl, Phenyl, das 1 bis 3 Substituenten aus der Reihe Cyan C₁₋₂₂-Alkyl, C₁₋₂₂-Alkoxy, Benzyl, Phenyl, 2,2,6,6-Tetramethyl-piperidyl-4-, Hydroxy, C₁₋₈-Alkyl-phenyl, Carboxyl, -C(CH₃)₂-C₆H₅, -COO-C₁₋₂₂-Alkyl, CH₂CH₁₂-COOH, -CH₂CH₂COO-, C₁-₂₂-Alkyl oder -CH₂-S-C₁₋₂₂-Alkyl tragen kann; oder eine Gruppe der Formel i bis vii. 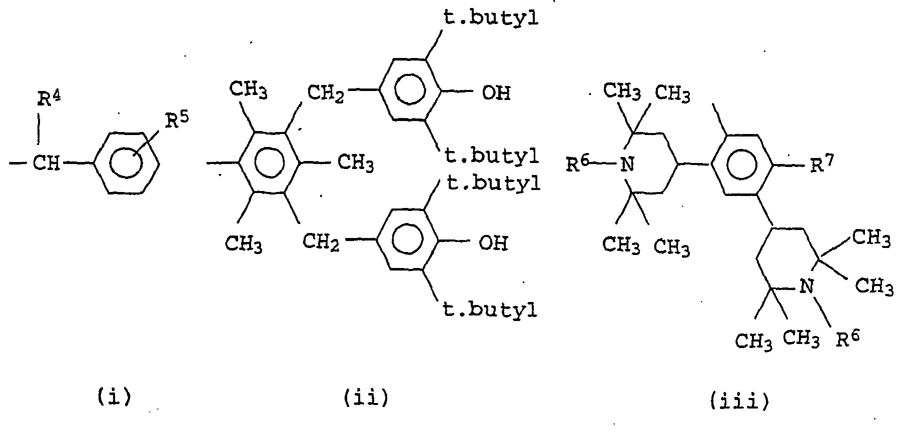 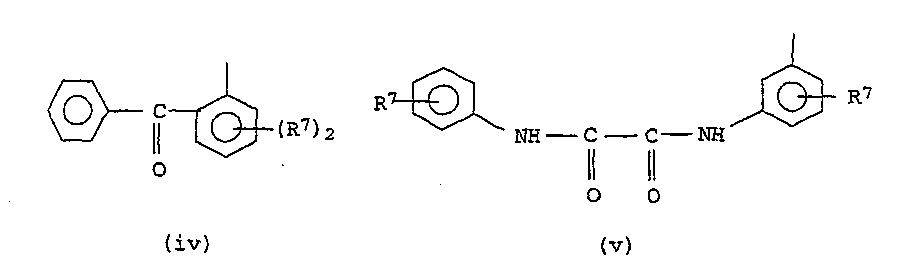 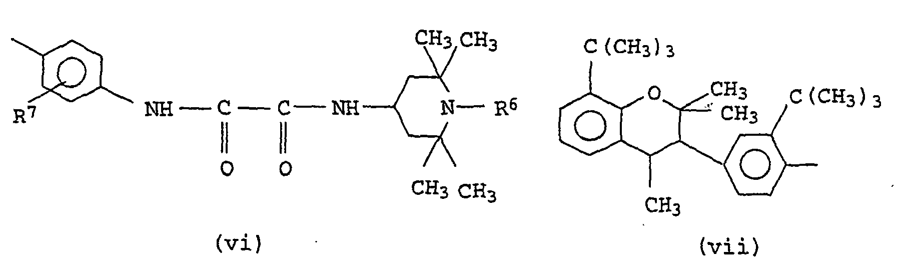 oder zwei R" gemeinsam eine Gruppe der Formel viii 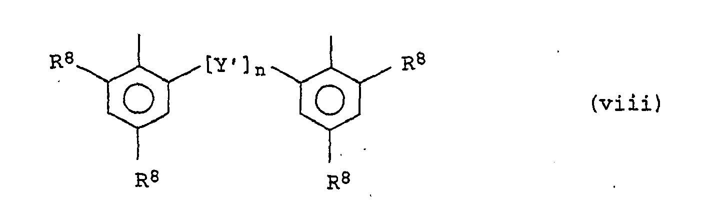 bedeuten, wobei
- R⁸: Wasserstoff oder C₁₋₂₂-Alkyl,
- R⁶: Wasserstoff, C₁₋₄-Alkyl oder -CO-C₁₋₈-Alkyl,
- R⁴: Wasserstoff oder C₁₋₂₂-Alkyl,
- R⁵: Wasserstoff, C₁₋₂₂-Alkyl, C₁₋₂₂-Alkoxy, Benzyl, Cyan, Phenyl, Hydroxyl, C₁₋₈-Alkylphenyl, C₁₋₂₂-Alkoxycarbonyl, C₁₋₂₂-Alkoxycarbonylethyl, Carboxyethyl, 2,2,6,6-Tetramethylpiperidyl-4- oder eine Gruppe der Formel -CH₂-S-C₁₋₂₂-Alkyl oder -C(CH₃)₂-C₆H₅ und
- R⁷: Wasserstoff, C₁₋₂₂-Alkyl, Hydroxy oder Alkoxy bedeuten und
- Y': und n die oben angegebenen Bedeutungen besitzen.

Insbesondere bevorzugt als Reste R sind die Reste R", die eine der Formeln a bis g 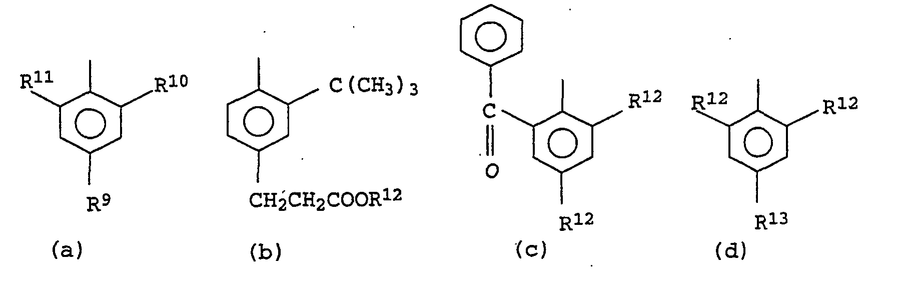 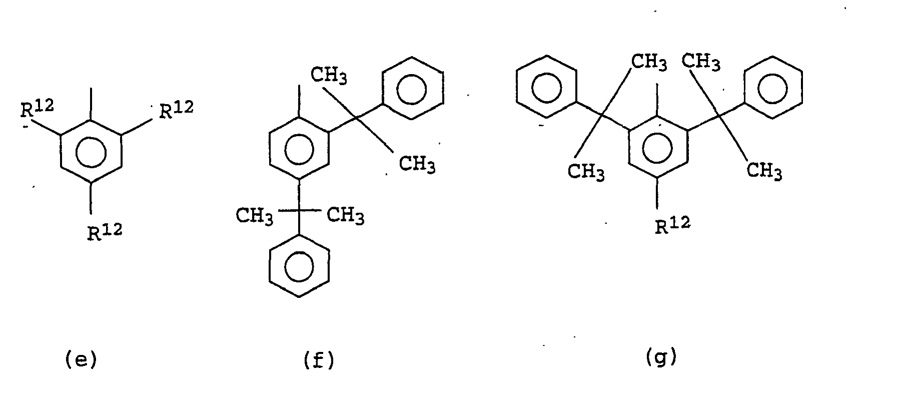 entsprechen, worin
- R⁹: Wasserstoff, C₁₋₈-Alkyl, C₁₋₈-Alkoxy, Phenyl, C₁₋₈-Alkylphenyl oder Phenyl-C₁₋₈-Alkylphenyl oder Phenyl-C₁₋₄-alkyl,
- R¹⁰: und R¹¹ unabhängig voneinander, Wasserstoff, C₁₋₂₂-Alkyl, Phenyl oder C₁₋₈-Alkylphenyl,
- R¹²: Wasserstoff oder C₁₋₈-Alkyl und
- R¹³: Cyan, Carboxyl oder C₁₋₈-Alkoxycarbonyl
bedeuten.

Unter den Gruppen der Formel a sind 2-tert.-Butylphenyl, 2-Phenylphenyl, 2-(1',1'-Dimethyl-propyl)-phenyl, 2-Cyclohexylphenyl, 2-tert.-Butyl-4-methylphenyl, 2,4-Di-tert.-amylphenyl, 2,4-Di-tert.-butylphenyl, 2,4-Di-phenylphenyl, 2,4-Di-tert.-octylphenyl, 2-tert.-Butyl-4-phenyl-phenyl, 2,4-Bis-(1',1'-dimethylpropyl)-phenyl, 2-(1'-Phenyl-1'-methylethyl)-phenyl, 2,4-Bis-(1'-Phenyl-1'-methylethyl)-phenyl und 2,4-Di-tert.-butyl-6-methylphenyl bevorzugt.

Verfahren zur Herstellung der Phosphonite D) sind der DE-A 40 01 397 zu entnehmen, welche in Mengen von 0,001 bis 5, vorzugsweise von 0,01 bis 3 Gew.-% in den Formmassen enthalten sein können.

Als weitere bevorzugte Stabilisatoren seien organische Phosphite der allgemeinen Formel II genannt: 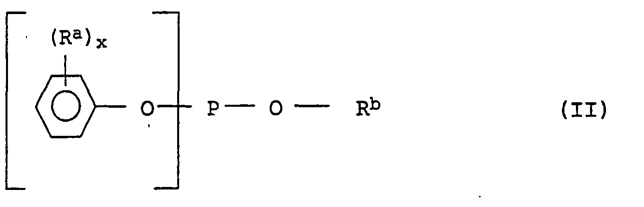 in der
- X: 1 bis 5
- R^{a}: ein aliphatischer Rest mit 1 bis 10 C-Atomen
- R^{b}: ein aliphatischer Rest mit 1 bis 30 C-Atomen, ein gegebenenfalls substituierter aromatischer Rest mit 1 bis 20 C-Atomen
bedeuten.

Bevorzugte Verbindungen sind 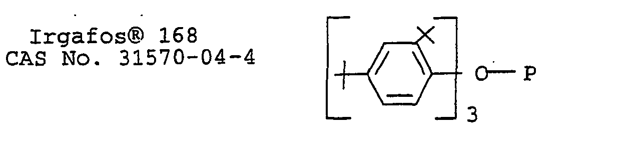 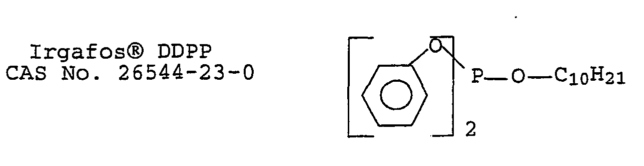 und 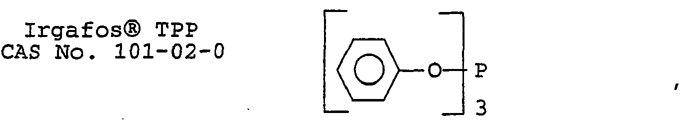 wobei 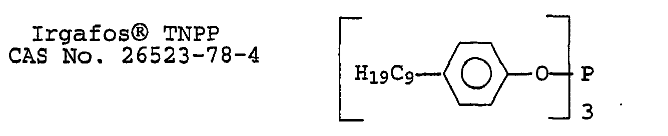 besonders bevorzugt ist.

Als weitere bevorzugte Stabilisatoren seien anorganische basische Phosphate genannt wie Erdalkali- oder Alkaliphosphate oder deren Mischungen. Insbesondere seien Zinkphosphat, Lithium-, Natrium-, Kalium-, Al-, Gallium- und Antimonphosphat genannt.

Als Komponente E) können die erfindungsgemäßen Formmassen 0 bis 70, vorzugsweise bis zu 50 Gew.-% weiterer Zusatzstoffe enthalten.

Es versteht sich von selbst, dass auch Mischungen der vorstehenden Stabilisatoren D) eingesetzt werden können.

Als Komponente E) können die erfindungsgemäßen Formmassen 0 bis 5, insbesondere 0,01 bis 5, vorzugsweise 0,05 bis 3 und insbesondere 0,1 bis 2 Gew.-% mindestens eines Esters oder Amids gesättigter oder ungesättigter aliphatischer Carbonsäuren mit 10 bis 40, bevorzugt 16 bis 22 C-Atomen mit aliphatischen gesättigten Alkoholen oder Aminen mit 2 bis 40, vorzugsweise 2 bis 6 C-Atomen enthalten.

Die Carbonsäuren können 1- oder 2-wertig sein. Als Beispiele seien Pelargonsäure, Palmitinsäure, Laurinsäure, Margarinsäure, Dodecandisäure, Behensäure und besonders bevorzugt Stearinsäure, Caprinsäure sowie Montansäure (Mischung von Fettsäuren mit 30 bis 40 C-Atomen) genannt.

Die aliphatischen Alkohole können 1- bis 4-wertig sein. Beispiele für Alkohole sind n-Butanol, n-Octanol, Stearylalkohol, Ethylenglykol, Propylenglykol, Neopentylglykol, Pentaerythrit, wobei Glycerin und Pentaerythrit bevorzugt sind.

Die aliphatischen Amine können 1- bis 3-wertig sein. Beispiele hierfür sind Stearylamin, Ethylendiamin, Propylendiamin, Hexamethylendiamin, Di(6-Aminohexyl)amin, wobei Ethylendiamin und Hexamethylendiamin besonders bevorzugt sind. Bevorzugte Ester oder Amide sind entsprechend Glycerindistearat, Glycerintristearat, Ethylendiamindistearat, Glycerinmonopalmitrat, Glycerintrilaurat, Glycerinmonobehenat und Pentaerythrittetrastearat.

Es können auch Mischungen verschiedener Ester oder Amide oder Ester mit Amiden in Kombination eingesetzt werden, wobei das Mischungsverhältnis beliebig ist.

Weitere Zusatzstoffe C) sind beispielsweise in Mengen bis zu 40, vorzugsweise bis zu 30 Gew.-% kautschukelastische Polymerisate (oft auch als Schlagzähmodifier, Elastomere oder Kautschuke bezeichnet).

Ganz allgemein handelt es sich dabei um Copolymerisate die bevorzugt aus mindestens zwei der folgenden Monomeren aufgebaut sind: Ethylen, Propylen, Butadien, Isobuten, Isopren, Chloropren, Vinylacetat, Styrol, Acrylnitril und Acryl- bzw. Methacrylsäureester mit 1 bis 18 C-Atomen in der Alkoholkomponente.

Derartige Polymere werden z.B. in Houben-Weyl, Methoden der organischen Chemie, Bd. 14/1 (Georg-Thieme-Verlag, Stuttgart, 1961). Seiten 392 bis 406 und in der Monographie von C.B. Bucknall, "Toughened Plastics" (Applied Science Publishers, London, 1977) beschrieben.

Im folgenden werden einige bevorzugte Arten solcher Elastomerer vorgestellt.

Bevorzugte Arten von solchen Elastomeren sind die sog. Ethylen-Propylen (EPM) bzw. Ethylen-Propylen-Dien-(EPDM)-Kautschuke.

EPM-Kautschuke haben im allgemeinen praktisch keine Doppelbindungen mehr, während EPDM-Kautschuke 1 bis 20 Doppelbindungen/100 C-Atome aufweisen können.

Als Dien-Monomere für EPDM-Kautschuke seien beispielsweise konjugierte Diene wie Isopren und Butadien, nicht-konjugierte Diene mit 5 bis 25 C-Atomen wie Penta-1,4-dien, Hexa-1,4-dien, Hexa-1,5-dien, 2,5-Dimethylhexa-1,5-dien und Octa-1,4-dien, cyclische Diene wie Cyclopentadien, Cyclohexadiene, Cyclooctadiene und Dicyclopentadien sowie Alkenylnorbornene wie 5-Ethyliden-2-norbornen, 5-Butyliden-2-norbornen, 2-Methallyl-5-norbornen, 2-Isopropenyl-5-norbornen und Tricyclodiene wie 3-Methyl-tricyclo(5.2.1.0.2.6)-3,8-decadien oder deren Mischungen genannt. Bevorzugt werden Hexa-1,5-dien, 5-Ethylidennorbornen und Dicyclopentadien. Der Diengehalt der EPDM-Kautschuke beträgt vorzugsweise 0,5 bis 50, insbesondere 1 bis 8 Gew.-%, bezogen auf das Gesamtgewicht des Kautschuks.

EPM- bzw. EPDM-Kautschuke können vorzugsweise auch mit reaktiven Carbonsäuren oder deren Derivaten gepfropft sein. Hier seien z.B. Acrylsäure, Methacrylsäure und deren Derivate, z.B. Glycidyl(meth)acrylat, sowie Maleinsäureanhydrid genannt.

Eine weitere Gruppe bevorzugter Kautschuke sind Copolymere des Ethylens mit Acrylsäure und/oder Methacrylsäure und/oder den Estern dieser Säuren. Zusätzlich können die Kautschuke noch Dicarbonsäuren wie Maleinsäure und Fumarsäure oder Derivate dieser Säuren, z.B. Ester und Anhydride, und/oder Epoxy-Gruppen enthaltende Monomere enthalten. Diese Dicarbonsäurederivate bzw. Epoxygruppen enthaltende Monomere werden vorzugsweise durch Zugabe von Dicarbonsäure- bzw. Epoxygruppen enthaltenden Monomeren der allgemeinen Formeln I oder II oder III oder IV zum Monomerengemisch in den Kautschuk eingebaut

R¹C(COOR²) =C (COOR³) R⁴ (I)

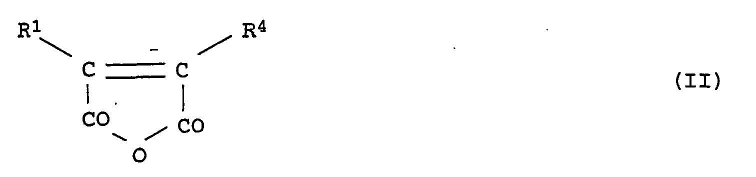

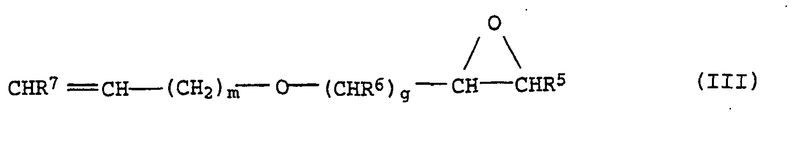

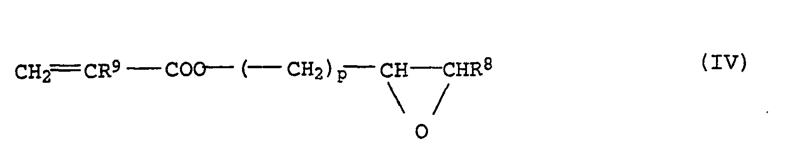

wobei R¹ bis R⁹ Wasserstoff oder Alkylgruppen mit 1 bis 6 C-Atomer darstellen und m eine ganze Zahl von 0 bis 20, g eine ganze Zahl von 0 bis 10 und p eine ganze Zahl von 0 bis 5 ist.

Vorzugsweise bedeuten die Reste R¹ bis R⁹ Wasserstoff, wobei m für 0 oder 1 und g für 1 steht. Die entsprechenden Verbindungen sind Maleinsäure, Fumarsäure, Maleinsäureanhydrid, Allylglycidylether und Vinylglycidylether.

Bevorzugte Verbindungen der Formeln I, II und IV sind Maleinsäure, Maleinsäureanhydrid und Epoxygruppen-enthaltende Ester der Acrylsäure und/oder Methacrylsäure, wie Glycidylacrylat, Glycidylmethacrylat und die Ester mit tertiären Alkoholen, wie t-Butylacrylat. Letztere weisen zwar keine freien Carboxylgruppen auf, kommen in ihrem Verhalten aber den freien Säuren nahe und werden deshalb als Monomere mit latenten Carboxylgruppen bezeichnet.

Vorteilhaft bestehen die Copolymeren aus 50 bis 98 Gew.-% Ethylen, 0,1 bis 20 Gew.-% Epoxygruppen enthaltenden Monomeren und/oder Methacrylsäure und/oder Säureanhydridgruppen enthaltenden Monomeren sowie der restlichen Menge an (Meth)acrylsäureestern.

Besonders bevorzugt sind Copolymerisate aus
- 50 bis 98,: insbesondere 55 bis 95 Gew.-% Ethylen,
- 0,1 bis 40,: insbesondere 0,3 bis 20 Gew.-% Glycidylacrylat und/oder Glycidylmethacrylat, (Meth)acrylsäure und/oder Maleinsäureanhydrid, und
- 1 bis 45,: insbesondere 10 bis 40 Gew.-% n-Butylacrylat und/ode 2-Ethylhexylacrylat.

Weitere bevorzugte Ester der Acryl- und/oder Methacrylsäure sind die Methyl-, Ethyl-, Propyl- und i- bzw. t-Butylester.

Daneben können auch Vinylester und Vinylether als Comonomere eingesetzt werden.

Die vorstehend beschriebenen Ethylencopolymeren können nach an sich bekannten Verfahren hergestellt werden, vorzugsweise durch statistische Copolymerisation unter hohem Druck und erhöhter Temperatur. Entsprechende Verfahren sind allgemein bekannt.

Bevorzugte Elastomere sind auch Emulsionspolymerisate, deren Herstellung z.B. bei Blackley in.der Monographie "Emulsion Polymerization" beschrieben wird. Die verwendbaren Emulgatoren und Katalystoren sind an sich bekannt.

Grundsätzlich können homogen aufgebaute Elastomere oder aber solche mit einem Schalenaufbau eingesetzt werden. Der schalenartige Aufbau wird durch die Zugabereihenfolge der einzelnen Monomeren bestimmt; auch die Morphologie der Polymeren wird von dieser Zugabereihenfolge beeinflußt.

Nur stellvertretend seien hier als Monomere für die Herstellung des Kautschukteils der Elastomeren Acrylate wie z.B. n-Butylacrylat und 2-Ethylhexylacrylat, entsprechende Methacrylate, Butadier und Isopren sowie deren Mischungen genannt. Diese Monomeren können mit weiteren Monomeren wie z.B. Styrol, Acrylnitril, Vinylethern und weiteren Acrylaten oder Methacrylaten wie Methylmethacrylat, Methylacrylat, Ethylacrylat und Propylacrylat copolymerisiert werden.

Die Weich- oder Kautschukphase (mit einer Glasübergangstemperatur von unter 0°C) der Elastomeren kann den Kern, die äußere Hülle oder eine mittlere Schale (bei Elastomeren mit mehr als zweischaligem Aufbau) darstellen; bei mehrschaligen Elastomeren können auch mehrere Schalen aus einer Kautschukphase bestehen.

Sind neben der Kautschukphase noch eine oder mehrere Hartkomponenten (mit Glasübergangstemperaturen von mehr als 20°C) am Aufba des Elastomeren beteiligt, so werden diese im allgemeinen durch Polymerisation von Styrol, Acrylnitril, Methacrylnitril, α-Methylstyrol, p-Methylstyrol, Acrylsäureestern und Methacrylsäureestern wie Methylacrylat, Ethylacrylat und Methylmethacrylat als Hauptmonomeren hergestellt. Daneben können auch hier geringere Anteile an weiteren Comonomeren eingesetzt werden.

In einigen Fällen hat es sich als vorteilhaft herausgestellt, Emulsionspolymerisate einzusetzen, die an der Oberfläche reaktive Gruppen aufweisen. Derartige Gruppen sind z.B. Epoxy-, Carboxyl-, latente Carboxyl-, Amino- oder Amidgruppen sowie funktionelle Gruppen, die durch Mitverwendung von Monomeren der allgemeinen Formel 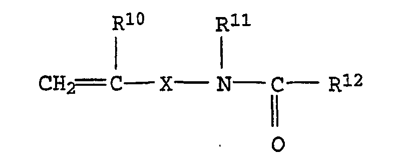 eingeführt werden können,
wobei die Substituenten folgende Bedeutung haben können:
- R¹⁰: Wasserstoff oder eine C₁- bis C₄-Alkylgruppe,
- R¹¹: Wasserstoff, eine C₁- bis C₈-Alkylgruppe oder eine Arylgruppe insbesondere Phenyl,
- R¹²: Wasserstoff, eine C₁- bis C₁₀-Alkyl-, eine C₆- bis C₁₂-Arylgruppe oder -OR¹³
- R¹³: eine C₁- bis C₈-Alkyl- oder C₆- bis C₁₂-Arylgruppe, die gegebenenfalls mit O- oder N-haltigen Gruppen substituiert sein können,
- X: eine chemische Bindung, eine C₁- bis C₁₀-Alkylen- oder C₆-C₁₂-Arylengruppe oder

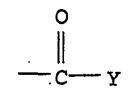

- Y: O-Z oder NH-Z und
- Z: eine C₁- bis C₁₀-Alkylen- oder C₆- bis C₁₂-Arylengruppe.

Auch die in der EP-A 208 187 beschriebenen Pfropfmonomeren sind zur Einführung reaktiver Gruppen an der Oberfläche geeignet.

Als weitere Beispiele seien noch Acrylamid, Methacrylamid und substituierte Ester der Acrylsäure oder Methacrylsäure wie (N-t-Butylamino)-ethylmethacrylat, (N,N-Dimethylamino)ethylacrylat, (*N,N*-Dimethylamino)-methylacrylat und (*N,N*-Diethylamino)ethylacrylat genannt.

Weiterhin können die Teilchen der Kautschukphase auch vernetzt sein. Als Vernetzer wirkende Monomere sind beispielsweise Buta-1,3-dien, Divinylbenzol, Diallylphthalat und Dihydrodicyclopentadienylacrylat sowie die in der EP-A 50 265 beschriebenen Verbindungen.

Ferner können auch sogenannten pfropfvernetzende Monomere (graftlinking monomers) verwendet werden, d.h. Monomere mit zwei oder mehr polymerisierbaren Doppelbindungen, die bei der Polymerisation mit unterschiedlichen Geschwindigkeiten reagieren. Vorzugsweise werden solche Verbindungen verwendet, in denen mindestens eine reaktive Gruppe mit etwa gleicher Geschwindigkeit wie die übrigen Monomeren polymerisiert, während die andere reaktive Gruppe (oder reaktive Gruppen) z.B. deutlich langsamer polymerisiert (polymerisieren). Die unterschiedlichen Polymerisationsgeschwindigkeiten bringen einen bestimmten Anteil an ungesättigten Doppelbindungen im Kautschuk mit sich. Wird anschließend auf einen solchen Kautschuk eine weitere Phase aufgepfropft, so reagieren die im Kautschuk vorhandenen Doppelbindungen zumindest teilweise mit den Pfropfmonomeren unter Ausbildung von chemischen Bindungen, d.h. die aufgepfropfte Phase ist zumindest teilweise über chemische Bindungen mit der Pfropfgrundlage verknüpft.

Beispiele für solche pfropfvernetzende Monomere sind Allylgruppen enthaltende Monomere, insbesondere Allylester von ethylenisch ungesättigten Carbonsäuren wie Allylacrylat, Allylmethacrylat, Diallylmaleat, Diallylfumarat, Diallylitaconat oder die entsprechenden Monoallylverbindungen dieser Dicarbonsäuren. Daneben gibt es eine Vielzahl weiterer geeigneter pfropfvernetzender Monomerer; für nähere Einzelheiten sei hier beispielsweise auf die US-PS 4 148 846 verwiesen.

Im allgemeinen beträgt der Anteil dieser vernetzenden Monomeren an dem schlagzäh modifizierenden Polymer bis zu 5 Gew.-%, vorzugsweise nicht mehr als 3 Gew.-%, bezogen auf das schlagzäh modifizierende Polymere.

Anstelle von Pfropfpolymerisaten mit einem mehrschaligen Aufbau können auch homogene, d.h. einschalige Elastomere aus Buta-1,3-dien, Isopren und n-Butylacrylat oder deren Copolymeren eingesetzt werden. Auch diese Produkte können durch Mitverwendung von vernetzenden Monomeren oder Monomeren mit reaktiven Gruppen hergestellt werden.

Beispiele für bevorzugte Emulsionspolymerisate sind n-Butylacrylat/(Meth)acrylsäure-Copolymere, n-Butylacrylat/Glycidylacrylat- oder n-Butylacrylat/Glycidylmethacrylat-Copolymere, Pfropipolymerisate mit einem inneren Kern aus n-Butylacrylat oder auf Butadienbasis und einer äußeren Hülle aus den vorstehend genannten Copolymeren und Copolymere von Ethylen mit Comonomeren, die reaktive Gruppen liefern.

Die beschriebenen Elastomere können auch nach anderen üblichen Verfahren, z.B. durch Suspensionspolymerisation, hergestellt werden.

Siliconkautschuke, wie in der DE-A 37 25 576, der EP-A 235 690, der DE-A 38 00 603 und der EP-A 319 290 beschrieben, sind ebenfalls bevorzugt.

Selbstverständlich können auch Mischungen der vorstehend aufgeführten Kautschuktypen eingesetzt werden.

Als faser- oder teilchenförmige Füllstoffe (Komponente E)) seien Kohlenstoffasern, Glasfasern, Glaskugeln, amorphe Kieselsäure, Asbest, Calciumsilicat, Calciummetasilicat, Magnesiumcarbonat, Kaolin, Kreide, gepulverter Quarz, Glimmer, Bariumsulfat und Feldspat genannt, die in Mengen bis zu 50 Gew.-%, insbesondere 1 bis 50 %, vorzugsweise 5 bis 40 und insbesondere 15 bis 35 Gew.-% eingesetzt werden.

Als bevorzugte faserförmige Füllstoffe seien Kohlenstoffasern, Aramid-Fasern und Kaliumtitanat-Fasern genannt, wobei Glasfasern als E-Glas besonders bevorzugt sind. Diese können als Rovings oder Schnittglas in den handelsüblichen Formen eingesetzt werden.

Die faserförmigen Füllstoffe können zur besseren Verträglichkeit mit dem Thermoplasten mit einer Silanverbindung oberflächlich vorbehandelt sein.

Geeignete Silanverbindungen sind solche der allgemeinen Formel

(X- (CH₂)ₙ)ₖ-Si- (O-CₘH₂ₘ₊₁)₄₋ₖ

in der die Substituenten folgende Bedeutung haben:
- X: NH₂-, 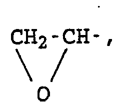 HO-,
- n: eine ganze Zahl von 2 bis 10, bevorzugt 3 bis 4
- m: eine ganze Zahl von 1 bis 5, bevorzugt 1 bis 2
- k: eine ganze Zahl von 1 bis 3, bevorzugt 1

Bevorzugte Silanverbindungen sind Aminopropyltrimethoxysilan, Aminobutyltrimethoxysilan, Aminopropyltriethoxysilan, Aminobutyltriethoxysilan sowie die entsprechenden Silane, welche als Substituent X eine Glycidylgruppe enthalten.

Die Silanverbindungen werden im allgemeinen in Mengen von 0,05 bis 5, vorzugsweise 0,5 bis 1,5 und insbesondere 0,8 bis 1 Gew.-% (bezogen auf C) zur Oberflächenbeschichtung eingesetzt.

Geeignet sind auch nadelförmige mineralische Füllstoffe.

Unter nadelförmigen mineralischen Füllstoffen wird im Sinne der Erfindung ein mineralischer Füllstoff mit stark ausgeprägtem nadelförmigen Charakter verstanden. Als Beispiel sei nadelförmiger Wollastonit genannt. Vorzugsweise weist das Mineral ein L/D-(Länge Durchmesser)-Verhältnis von 8 : 1 bis 35 : 1, bevorzugt von 8 : 1 bis 11 : 1 auf. Der mineralische Füllstoff kann gegebenenfalls mit den vorstehend genannten Silanverbindungen vorbehandelt sein; die Vorbehandlung ist jedoch nicht unbedingt erforderlich.

Als weitere Füllstoffe seien Kaolin, calciniertes Kaolin, Wollastonit, Talkum und Kreide genannt.

Es können anorganische Pigmente, wie Ultramarinblau, Eisenoxid, Titandioxid, Zinksulfid und Ruß, weiterhin organische Pigmente, wie Phthalocyanine, Chinacridone, Perylene sowie Farbstoffe, wie Nigrosin und Anthrachinone als Farbmittel zugesetzt werden.

Als Keimbildungsmittel können Natriumphenylphosphinat, Aluminiumoxid, Siliziumdioxid sowie bevorzugt Talkum eingesetzt werden.

Weitere Gleit- und Entformungsmittel, welche üblicherweise in Mengen bis zu 1 Gew.-% eingesetzt werden, sind bevorzugt langkettige Fettsäuren (z.B. Stearinsäure oder Behensäure), deren Salze (z.B. Ca- oder Zn-Stearat) oder Montanwachse (Mischungen aus geradkettigen, gesättigten Carbonsäuren mit Kettenlängen von 28 bis 32 C-Atomen) bzw. deren Alkali und/oder Erdalkalisalze, vorzugsweise Ca-Montanat und Na-Montanat sowie niedermolekulare Polyethylen- bzw. Polypropylenwachse.

Als Beispiele für Weichmacher seien Phthalsäuredioctylester, Phthalsäuredibenzylester, Phthalsäurebutylbenzylester, Kohlenwasserstofföle, N-(n-Butyl)benzolsulfonamid genannt.

Die erfindungsgemäßen Formmassen können noch 0 bis 5 Gew.-%, vorzugsweise 0,1 bis 3 Gew.-% eines Antitropfmittels, wie fluorhaltige Ethylenpolymerisate enthalten. Hierbei handelt es sich um Polymerisate des Ethylens mit einem Fluorgehalt von 55 bis 76 Gew.-%, vorzugsweise 70 bis 76 Gew.-%.

Beispiele hierfür sind Polytetrafluorethylen (PTFE), Tetrafluorethylen-hexafluorpropylen-Copolymere oder Tetrafluorethylen-Copolymerisate mit kleineren Anteilen (in der Regel bis zu 50 Gew.-%) copolymerisierbarer ethylenisch ungesättigter Monomerer. Diese werden z.B. von Schildknecht in "Vinyl and Related Polymers", Wiley-Verlag, 1952, Seite 484 bis 494 und von Wall in "Fluorpolymers" (Wiley Interscience, 1972) beschrieben.

Diese fluorhaltigen Ethylenpolymerisate liegen homogen verteilt in den Formmassen vor und weisen bevorzugt eine Teilchengröße d₅₀ (Zahlenmittelwert) im Bereich von 0,05 bis 10 µm, insbesondere von 0,1 bis 5 µm auf. Diese geringen Teilchengrößen lassen sich besonders bevorzugt durch Verwendung von wäßrigen Dispersionen von fluorhaltigen Ethylenpolymerisaten und deren Einarbeitung in eine Polyesterschmelze erzielen.

Die erfindungsgemäßen thermoplastischen Formmassen können nach an sich bekannten Verfahren hergestellt werden, in dem man die Ausgangskomponenten in üblichen Mischvorrichtungen wie Schneckenextrudern, Brabender-Mühlen oder Banbury-Mühlen mischt und anschließend extrudiert. Nach der Extrusion kann das Extrudat abgekühlt und zerkleinert werden. Es können auch einzelne Komponenten vorgemischt werden und dann die restlichen Ausgangsstoffe einzeln und/oder ebenfalls gemischt hinzugegeben werden. In einer bevorzugten Ausführungsform können bei Anwesenheit der Komponente D) diese vorab mit Komponente C) gemischt werden und/oder bevorzugt bei Raumtemperatur bis 180°C auf das Granulat A) aufgebracht werden. Ebenso bevorzugt ist die Zugabe eines Schmiermittels E) bereits bei Erreichen von mind. 80 % der gewünschten Endviskosität bei der Herstellung der Komponente A). Die Mischtemperaturen liegen in der Regel bei 230 bis 290°C.

Nach einer bevorzugten Arbeitsweise können die Komponenten B) bis C) mit einem Polyesterpräpolymeren gemischt, konfektioniert und granuliert werden. Das erhaltene Granulat wird in fester Phase anschließend unter Inertgas kontinuierlich oder diskontinuierlich bei einer Temperatur unterhalb des Schmelzpunktes der Komponente A) bis zur gewünschten Viskosität kondensiert.

Bevorzugte thermoplastische Formmassen enthalten
1 bis 98 Gew.-% A)
1 bis 30 Gew.-% B)
0,01 bis 5 Gew.-% C) 0,11 bis 5 Gew.-% D).

Die erfindungsgemäßen thermoplastischen Formmassen zeichnen sich durch gutes Kristallisationsverhalten und gute Flammschutzeigenschaften aus. Die Verarbeitung erfolgt weitestgehend ohne Veränderung der Polymermatrix (Verfärbung). Weiterhin zeichnen die Formmassen sich durch eine gute Stabilität des Molekulargewichtes bei der Verarbeitung aus, sowie kurze Zykluszeiten und gutes Entformungsverhalten. Sie eignen sich zur Herstellung von Fasern, Folien und Formkörpern, insbesondere für Anwendungen im Elektro- und Elektronikbereich. Diese Anwendungen sind insbesondere Lampenteile wie Lampenfassungen und -halterungen, Stecker und Stekkerleisten, Spulenkörper, Gehäuse für Kondensatoren oder Schaltschütze sowie Sicherungsschalter, Relaisgehäuse und Reflektoren.

### Beispiele

Komponente a₁: Polybutylenterephthalat mit einer Viskositätszahl von 130 ml/g und einem Carboxylendgruppengehalt von 25 mval/kg (VZ gemessen in 0,5 gew.-%iger Lösung aus Phenol/o-Dichlorbenzol, 1:1-Mischung bei 25°C gemäß ISO 1628), enthaltend 0,65 Gew.-%, bezogen auf A1 Pentaerythrittetrastearat (Komponente E1),
Komponente a₂: PET mit einer VZ von 76 ml/g.

### Komponente b₁

Tetrabrombisphenol-A-Oligocarbonat n ~ 4-5
(BC 52/58 der Firma Great Lakes)
Mₙ ≈ 2500

### Komponente b₂

Antimontrioxid (als Konzentrat 90 %ig in Polyethylen)
Komponente C1
Kaliumhydrogentartrat
Komponente C2
Weinsäure (in Pulverform)
Komponente CV (zum Vergleich)
Zitronensäure (gepulvert)
Komponente D l
Irgafos® TNPP der Firma Ciba Geigy Spez. Chemie GmbH

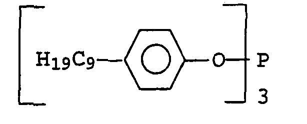

### Komponente D 2

Irgafos® PEPQ der Firma Ciba Geigy Spez. Chemie GmbH

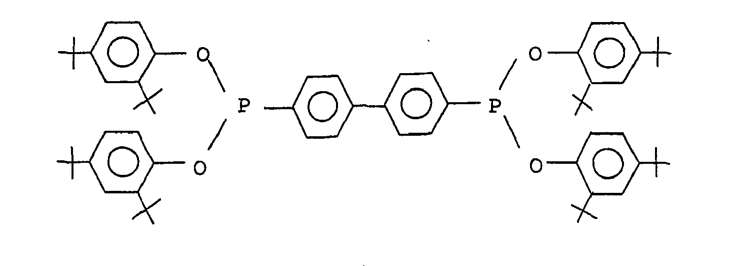

### Komponente D 3

Li₃(PO₄)
Komponente DV
Zn(H₂PO₄) ₂
Komponente E 2
Schnittglasfasern mit einer mittleren Länge von 4 mm (epoxysilanisierte Schlichte)

### Komponente E 3

Polytetrafluoroethylen (Teflon) mit SAN umhüllt (50:50) (Blendex® 449 der Firma General Electric Plastics

### Herstellung der Formmassen

Die Komponente A) bis E) wurden in den in der Tabelle angegebenen Mengenverhältnissen auf einem Extruder bei 260°C gemischt, homogenisiert, granuliert und getrocknet. Komponenten C und D wurden bei RT vorgemischt.

Es wurden folgende DSC-Messungen durchgeführt
1) TM 2 wurde folgendermaßen ermittelt
   a) Vortemperung 3 min bei 40°C
   b) Aufheizen von 40°C auf 300°C mit 20 k/min
   c) 1 min bei 300°C halten
   d) Abkühlen von 300°C auf 40°C mit 20 k/min
   e) 1 min bei 40°C halten
   f) 2. Aufheizen von 40°C auf 300°C mit 20 k/min
2) TKB wurde wie folgt ermittelt:
   a) Vorgehen Punkte a-d analog TM₂
   b) Messung der onset-Temperatur bei Kristallationsbeginn an der Erstarrungsexotherme
3) TKM wurde wie folgt ermittelt:
   a) Vorgehen Punkte a-d analog TM₂
   b) Bestimmung der Temperatur am Maximum der Kristallationsexotherme

Die Zusammensetzung der Formmassen und die Ergebnisse der Messungen sind der Tabelle zu entnehmen.

| Beispiel | 1 | 1 V | 2 | 3 | 4 | 5 | 2 V | 3 V | 6 | 7 | 8 |
|---|---|---|---|---|---|---|---|---|---|---|---|
| Zusammensetzung [Gew.-%] a1 + E1 | 36,2 +0,5 | 36,3 +0,5 | 36 +0,5 | 35,7 +0,5 | 35,3 +0,5 | 36,1 +0,5 | 36,1 +0,5 | 36,3 +0,5 | 35,9 +0,5 | 36,25 +0,5 | 36,2 +0,5 |
| a2 | 15 | 15 | 15 | 15 | 15 | 15 | 15 | 15 | 15 | 15 | 15 |
| b1 | 12 | 12 | 12 | 12 | 12 | 12 | 12 | 12 | 12 | 12 | 12 |
| b2 | 5,5 | 5,5 | 5,5 | 5,5 | 5,5 | 5,5 | 5,5 | 5,5 | 5,5 | 5,5 | 5,5 |
| C | 0,3 C1 | 0,2 CV | 0,5 C1 | 0,2 C2 | 0,2 C2 | 0,2 C2 | 0,4 CV | - | 0,1 C2 | 0,25 C2 | 0,15 C2 |
| D | - | - | - | 0,6 D1 | 1 D2 | 0,2 D3 | - | 0,2 DV | 0,5 D2 | - | 0,15 D3 |
| E2 | 30 | 30 | 30 | 30 | 30 | 30 | 30 | 30 | 30 | 30 | 30 |
| E3 | 0,5 | 0,5 | 0,5 | 0,5 | 0,5 | 0,5 | 0,5 | 0,5 | 0,5 | 0,5 | 0,5 |
| TM 2 [°C] | 201 | 195,8 | 198 | 195 | 196 | 196 | 192 | 195 | 200 | 195 | 201 |
| TKB [°C] | 185 | 179 | 182 | 178 | 178 | 176 | 174 | 177 | 181 | 178 | 183 |
| TKM [°C] | 167,4 | 163,4 | 167 | 163 | 163 | 163 | 158 | 162 | 168 | 163 | 166 |

## Patentansprüche

1. Thermoplastische Formmassen enthaltend
A) 10 bis 98 Gew.-% mindestens eines thermoplastischen Polyesters
B) 1 bis 30 Gew.-% einer Flammschutzmittelkombination aus, bezogen auf 100 Gew.-% B),
b₁) 20 bis 99 Gew.-% eines halogenhaltigen Flammschutzmittels
b₂) 1 bis 80 Gew.-% eines Antimontrioxides oder Antimonpentoxides
C) 0,01 bis 5 Gew.-% Weinsäure oder Tartrate oder deren Mischungen
D) 0 ist 5 Gew.-% mindestens eines phosphorhaltigen Stabilisators
E) 0 bis 70 Gew.-% weiterer Zusatzstoffe, wobei die Summe der Gewichtsprozente der Komponenten A) bis E) 100 % ergibt.

2. Thermoplastische Formmassen nach Anspruch 1, enthaltend
1 bis 98 Gew.-% A)
1 bis 30 Gew.-% B)
0,01 bis 5 Gew.-% C)
0,11 bis 5 Gew.-% D)

3. Thermoplastische Formmassen nach den Ansprüchen 1 oder 2, in denen die Komponente D) aus einem organischen Phosphonit oder organischen Phosphit oder einem anorganischen basischen Phosphates oder deren Mischungen aufgebaut ist.

4. Thermoplastische Formmassen nach den Ansprüchen 1 bis 3, in denen die Komponente D) aus einem organischen Phosphonit der allgemeinen Formel (I) aufgebaut ist: 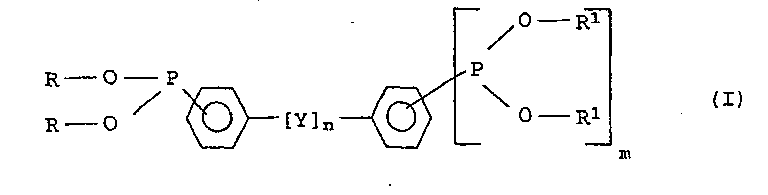 worin
in 0 oder 1,
n 0 oder 1,
Y eine Sauerstoff-Schwefel- oder 1,4-Phenylen-Brücke oder ein Brückenglied der Formel -CH(R²)-;
alle R-O- und R¹-O-Gruppen unabhängig voneinander, den Rest eines aliphatischen, alicyclischen oder aromatischen Alkohols, der bis zu drei Hydroxylgruppen enthalten kann, wobei jedoch die Hydroxylgruppen nicht so angeordnet sind, daß sie Teile eines Phosphor-enthaltenden Ringes sein können (als monovalente R-O-Gruppen bezeichnet), oder je zwei an ein Phosphoratom gebundene R-O-, bzw. R¹-Gruppen, jeweils unabhängig voneinander zusammen den Rest eines aliphatischen, alicyclischen oder aromatischen Alkohols mit insgesamt bis zu drei Hydroxylgruppen (als bivalente R-O-, bzw. R¹-O-Gruppen bezeichnet),
R² Wasserstoff, C₁-C₈-Alkyl oder eine Gruppe der Formel COOR³ und
R³ C₁₋₈-Alkyl bedeuten.

5. Thermoplastische Formmassen nach den Ansprüchen 1 bis 3, in denen das org. Phosphit D) die allgemeine Formel (II) aufweist: 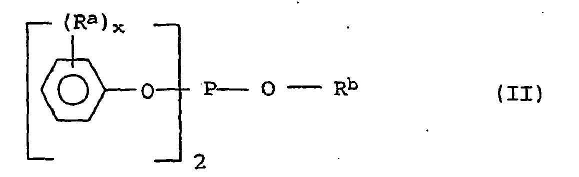 worin
x 1 bis 5
R^{a} ein aliphatischer Rest mit 1 bis 10 C-Atomen
R^{b} ein aliphatischer Rest mit 1 bis 30 C-Atomen,
ein gegebenenfalls substituierter aromatischer Rest mit 1 bis 20 C-Atomen
bedeuten.

6. Thermoplastische Formmassen nach den Ansprüchen 1 bis 5 in denen das anorganische basische Phosphat D) aus Zinkphosphat, Aluminiumphosphat, Galliumphosphat, Antimonphosphat, Erdalkali- oder Alkaliphosphate oder deren Mischungen aufgebaut ist.

7. Thermoplastische Formmassen nach den Ansprüchen 1 bis 6, enthaltend Alkali- oder Erdalkalitartrate oder Ester der Weinsäure oder deren Mischungen als Komponente C).

8. Thermoplastische Formmassen nach den Ansprüchen 1 bis 7, in denen die Komponente C aus Kalium-, Kaliumhydrogen-, Kaliumnatrium-, Natrium-, Natriumhydrogentartraten oder deren Mischungen aufgebaut ist.

9. Verwendung der Formmassen gemäß den Ansprüchen 1 bis 8 zur Herstellung von Formkörpern, Folien oder Fasern.

10. Formteile jeglicher Art, erhältlich aus den thermoplastischen Formmassen gemäß den Ansprüchen 1 bis 8.

11. Spulengehäuse, Spulenkörper, Spulenträger, Kondensatorbecher, Steckverbinder, Steckerleisten, Steckerbrücken, Chipträger, Leiterplatten, Lampenteile, Lampenfassungen, Startergehäuse, Transformatorgehäuse,Akkugehäuse, Lüfterräder, Zarge für Lüfterräder, Lampensockel, Leuchtenabdeckung, Leuchtenträger, Lichtschalter, Elektrokleingeräte, Bügeleisengehäuse, Schaltanlagen, Leistungsschutzschalter, Ladegeräte, Steckdosen, Motorenbauteile, Generatorenbauteile, Reihenklemmen erhältlich aus den thermoplastischen Formmassen gemäß den Ansprüchen 1 bis 8.

## Claims

1. A thermoplastic molding composition comprising
A) from 10 to 98% by weight of at least one thermoplastic polyester
B) from 1 to 30% by weight of a flame retardant combination made from, based on 100% by weight of B),
b₁) from 20 to 99% by weight of a halogen-containing flame retardant,
b₂) from 1 to 80% by weight of an antimony trioxide or antimony pentoxide
C) from 0.01 to 5% by weight of tartaric acid or tartrates or mixtures of these
D) from 0 to 5% by weight of at least one phosphorus-containing stabilizer
E) from 0 to 70% by weight of other additives, where the total of the percentages by weight of components A) to E) is 100%.

2. The thermoplastic molding composition according to claim 1 comprising
from 1 to 98% by weight of A)
from 1 to 30% by weight of B)
from 0.01 to 5% by weight of C)
from 0.11 to 5% by weight of D).

3. The thermoplastic molding composition according to claim 1 or 2, in which component D) is composed of an organic phosphonite or organic phosphite or of an inorganic basic phosphate or of a mixture of these.

4. The thermoplastic molding composition according to any of claims 1 to 3, in which component D) is composed of an organic phosphonite of the formula (I): 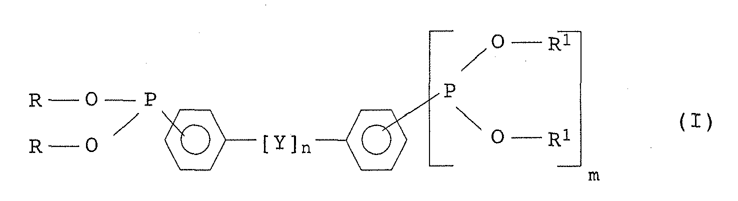 where
m is 0 or 1,
n is 0 or 1,
Y is an oxygen bridge, a sulfur bridge, or a 1,4-phenylene bridge, or a bridging unit of the formula -CH(R²)-;
each of the R-O- and R¹-O- groups, independently of one another, is the radical of an aliphatic, alicyclic, or aromatic alcohol which may comprise up to three hydroxyl groups, but excluding any arrangement of the hydroxyl groups which permits these to be part of a phosphorus-comprising ring (termed monovalent R-O-groups),
or, independently of one another in each case, two, R-O- or, respectively, R¹-O- groups bonded to a phosphorus atom are together the radical of an aliphatic, alicyclic, or aromatic alcohol having a total of up to three hydroxyl groups (termed bivalent R-O- or R¹-O- groups),
R² is hydrogen, C₁-C₈-alkyl, or a group of the formula COOR³, and
R³ is C₁₋₈-alkyl.

5. The thermoplastic molding composition according to any of claims 1 to 3, in which the org. phosphite D) has the formula (II): 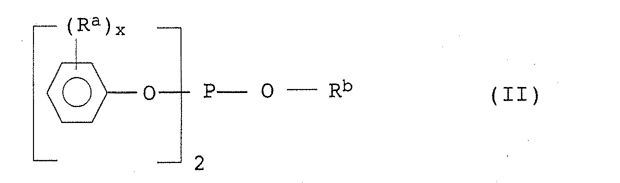 where
x is from 1 to 5
R^{a} is an aliphatic radical having from 1 to 10 carbon atoms
R^{b} is an aliphatic radical having from 1 to 30 carbon atoms, or
an optionally substituted aromatic radical having from 1 to 20 carbon atoms.

6. The thermoplastic molding composition according to any of claims 1 to 5 in which the inorganic basic phosphate D) is composed of zinc phosphate, aluminum phosphate, gallium phosphate, antimony phosphate, alkaline earth metal phosphates, or alkali metal phosphates, or a mixture of these.

7. The thermoplastic molding composition according to any of claims 1 to 6, comprising, as component C), alkali metal tartrates or alkaline earth metal tartrates, or esters of tartaric acid, or a mixture of these.

8. The thermoplastic molding composition according to any of claims 1 to 7, in which component C is composed of potassium tartrates, potassium hydrogen tartrates, potassium sodium tartrates, sodium tartrates, sodium hydrogen tartrates, or a mixture of these.

9. The use of the molding compositions according to any of claims 1 to 8 for producing moldings, films, or fibers.

10. A molding of any type, obtainable from the thermoplastic molding compositions according to any of claims 1 to 8.

11. A coil housing, a coil former, a coil carrier, a capacitor cup, a plug connector, a multipoint connector, a plug bridge, a chip carrier, a printed circuit board, a lamp part, a lamp holder, a starter housing, a transformer housing, a battery housing, a fan impeller, a housing for a fan impeller, a lamp socket, a protective covering for lamps, a lamp carrier, a lamp switch, a small electrical device, a housing for a clothes iron, a piece of switchgear, a power breaker, a charger, a plug socket, an engine component, a generator component, or terminal strip made from the thermoplastic molding compositions according to any of claims 1 to 8.

## Revendications

1. Masses de moulage thermoplastiques contenant
A) 10 à 98 % en poids d'au moins un polyester thermoplastique,
B) 1 à 30 % en poids d'une combinaison d'agents ignifugeants à base, par rapport à 100 % en poids de B),
b₁) de 20 à 99 % en poids d'un agent ignifugeant contenant de l'halogène,
b₂) de 1 à 80 % en poids d'un trioxyde ou pentoxyde d'antimoine,
C) 0,01 à 5 % en poids d'acide tartrique ou de tartrates ou de leurs mélanges,
D) 0 à 5 % en poids d'au moins un stabilisant contenant du phosphore,
E) 0 à 70 % en poids d'autres additifs,
la somme des % en poids des composants A) à E) donnant 100 %.

2. Masses de moulage thermoplastiques suivant la revendication 1, contenant
1 à 98 % en poids de A)
1 à 30 % en poids de B)
0,01 à 5 % en poids de C)
0,11 à 5 % en poids de D).

3. Masses de moulage thermoplastiques suivant les revendications 1 ou 2, dans lesquelles le composant D) est constitué d'un phosphonite organique ou d'un phosphite organique ou d'un phosphate basique inorganique ou de leurs mélanges.

4. Masses de moulage thermoplastiques suivant les revendications 1 à 3, dans lesquelles le composant D) est constitué d'un phosphonite organique de la formule générale (I) : 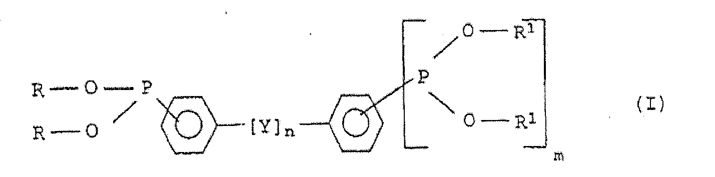 dans laquelle
m vaut 0 ou 1,
n vaut 0 ou 1,
Y représente un pont oxygène, soufre ou 1,4-phénylène ou un terme de pont de la formule -CH(R²)-,
tous les groupes R-O- et R¹-O- représentant indépendamment les uns des autres le radical d'un alcool aliphatique, alicyclique ou aromatique qui peut contenir jusqu'à trois groupes hydroxyle, les groupes hydroxyle n'étant cependant pas agencés de façon à ce qu'ils puissent être des parties d'un noyau contenant du phosphore (désignés par groupes R-O- monovalents), ou chacun des deux groupes R-O- ou R¹-O- fixés sur un atome de phosphore représentant, chaque fois indépendamment les uns des autres, conjointement le radical d'un alcool aliphatique, alicyclique ou aromatique comportant au total jusqu'à trois groupes hydroxyle (désignés par groupes R-O- ou R¹-O-bivalents),
R² représente de l'hydrogène ou un groupe alkyle en C₁-C₈ ou un groupe de la formule COOR³, et
R³ représente un groupe alkyle en C₁-C₈.

5. Masses de moulage thermoplastiques suivant les revendications 1 à 3, dans lesquelles le phosphite organique D) présente la formule générale (II) : 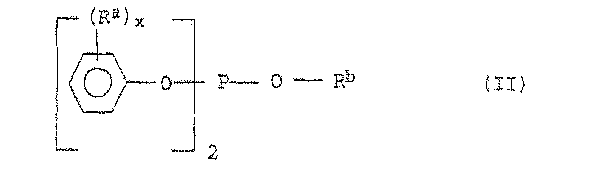 dans laquelle
x vaut 1 à 5,
R^{a} est un radical aliphatique comportant 1 à
10 atomes de C,
R^{b} est un radical aliphatique comportant 1 à 30 atomes de C, ou un radical aromatique éventuellement substitué comportant 1 à 20 atomes de C.

6. Masses de moulage thermoplastiques suivant les revendications 1 à 5, dans lesquelles le phosphate basique inorganique D) est constitué de phosphate de zinc, de phosphate d'aluminium, de phosphate de gallium, de phosphate d'antimoine, de phosphates de métaux alcalino-terreux ou alcalins ou de leurs mélanges.

7. Masses de moulage thermoplastiques suivant les revendications 1 à 6, contenant des tartrates de métal alcalin ou de métal alcalino-terreux ou des esters de l'acide tartrique ou leurs mélanges, comme composant C).

8. Masses de moulage thermoplastiques suivant les revendications 1 à 7, dans lesquelles le composant C) est constitué de tartrate de potassium, d'hydrogénotartrate de potassium, de tartrate de potassium et de sodium, de tartrate de sodium, d'hydrogénotartrate de sodium ou de leurs mélanges.

9. Utilisation des masses de moulage suivant les revendications 1 à 8, pour la préparation de corps façonnés, de feuilles ou de fibres.

10. Pièces moulées de n'importe quel type, que l'on peut obtenir à partir des masses de moulage thermoplastiques suivant les revendications 1 à 8.

11. Boîtiers de bobine, armatures de bobine, porte-bobines, boîtiers de condensateur, connecteurs, broches de connecteur, ponts de connecteur, supports de puce, cartes imprimées, pièces de lampe, douilles de lampe, boîtiers de démarreur, boîtiers de transformateur, boîtiers d'accumulateur, roues de ventilateur, châssis de roues de ventilateur, socles de lampe, écrans de lampe, supports de lampe, interrupteurs, petits appareils ménagers électriques, boîtiers de fer à repasser, installations de commutation, commutateurs de protection de puissance, chargeurs de batterie, prises femelles, pièces de construction de moteurs, pièces de construction de générateurs, barrettes à bornes, que l'on peut obtenir à partir des masses de moulage thermoplastiques suivant les revendications 1 à 8.
